# EUROPEAN PATENT SPECIFICATION

(11) **EP 2 907 135 B1**
(45) Date of publication and mention of the grant of the patent: **31.08.2016**
(21) Application number: 13783431.3
(22) Date of filing: 08.10.2013
(51) Int. Cl.: G11C 11/34, H01L 27/28, H01L 51/30

(54) **RESISTIVE MEMORY DEVICE FABRICATED FROM SINGLE POLYMER MATERIAL**
AUS EINEM EINZELNEN POLYMERMATERIAL HERGESTELLTE RESISTIVE SPEICHERVORRICHTUNG
DISPOSITIF DE MÉMOIRE RÉSISTIVE FABRIQUÉ À PARTIR D'UN SEUL MATÉRIAU POLYMÈRE

(30) Priority: 09.10.2012 US 201261711281 P
(43) Date of publication of application: 19.08.2015
(73) Proprietor: Saudi Basic Industries Corporation, 11422 Riyadh (SA)
(72) Inventor: ALSHAREEF, Husam N., 4700 Kaust Thuwal (SA); KHAN, Mohd Adnan, 4700 Kaust Thuwal (SA); BHANSALI, Unnat S., 4700 Kaust Thuwal (SA); ALMADHOUN, Mahmoud, 23955-6900 Kaust Thuwal (SA)
(74) Representative: Balder IP Law, S.L.
(86) International application number: PCT/US2013/063847
(87) International publication number: WO 2014/058858

(56) References cited:
- WO-A1-02/43071
- US-A1- 2004 149 552

## Description

### CROSS-REFERENCE TO RELATED APPLICATION

This application claims the benefit of U.S. Provisional Application No. 61/711,281 filed October 9, 2012.

### BACKGROUND OF THE INVENTION

This disclosure relates generally to memory devices and their methods of manufacture, and more particularly, to resistive memory devices fabricated from single polymer material and their methods of manufacture.

Memory technologies can be broadly divided into two categories: volatile and non-volatile. Volatile memories, such as SRAM (static random access memory) and DRAM (dynamic random access memory), lose their contents when power is removed. On the other hand, non-volatile memories, which are based on both ROM (read only memory) technology such as EPROM (erasable programmable read only memory) and WORM (write once read many times) and hybrid technology such as flash and ferroelectric memory, do not lose their contents. DRAM, SRAM, and other semiconductor memories are widely used for the processing and high-speed storage of information in computers and other devices. In recent years, electrically erasable programmable ROM ("EEPROMs") and flash memory have been introduced as non-volatile memories that store data as electrical charges in floating-gate electrodes. Non-volatile memories ("NVMs") are used in a wide variety of commercial and military electronic devices and equipment, such as hand-held telephones, radios, and digital cameras. One particular type of NVMs is WORM memory, where information, once written, cannot be modified. WORM devices are useful in archiving information when users want the security of knowing it has not been modified since initial write, which might imply tampering.

Memory device structures can be constructed by sandwiching an active polymer layer between conducting metal/oxide electrodes such as gold, aluminum, silver, or ITO (indium tin oxide). However, the use of metal/oxide electrodes requires high vacuum and high temperature processing, thus increasing the cost of these devices. In addition, the devices having metal/oxide electrodes lack transparency and flexibility, and are not suitable for use in flexible electronics.

Flexible electronics have recently attracted considerable attention due to their range of applications, for example, smart cards, biomedical sensors, and foldable antennas. To realize these applications, the development of flexible non-volatile memory devices for data storage or radio-frequency transponders ("RFID") is required. Accordingly, there is still a need for materials and methods for the manufacture of organic devices. It would be an advantage if such devices had low power consumption. It would also be desirable if the devices could be made at low temperature in a cost effective manner.

WO 02/43071 A1 discloses a ferroelectric memory cell comprising a ferroelectric polymer thin film and first and second electrodes.

### SUMMARY OF THE INVENTION

In an aspect, disclosed herein is a polymer-based device comprising a substrate; a first electrode disposed on the substrate; an active polymer layer disposed on and in contact with the first electrode; and a second electrode disposed on and in contact with the active polymer layer, wherein the first and the second electrodes are organic electrodes comprising a doped electroconductive organic polymer, the active polymer layer comprises the electroconductive organic polymer of the first and the second electrodes, and the first and the second electrodes have conductivity at least three orders of magnitude higher than the conductivity of the active polymer layer.

In another aspect, disclosed herein is a polymer-based device comprising a substrate; a first electrode disposed on the substrate; an active polymer layer disposed on and in contact with the first electrode; and a second electrode disposed on and in contact with the active polymer layer, wherein the first and the second electrodes are organic electrodes comprising a doped poly(3,4-ethylenedioxythiophene)-poly(styrenesulfonate), the active polymer layer comprises the poly(3,4-ethylenedioxythiophene)-poly(styrenesulfonate) of the first and the second electrodes, and the first and the second electrodes have conductivity at least three orders of magnitude higher than the conductivity of the active polymer layer.

In yet another aspect, disclosed herein is a method of making a polymer-based device. The method comprises disposing a first electrode on a substrate; disposing an active polymer layer on the first electrode; and disposing a second electrode on the active polymer layer, wherein the first and the second electrodes are organic electrodes comprising a doped electroconductive organic polymer, the active polymer layer comprises the electroconductive organic polymer of the first and the second electrodes, and the first and the second electrodes have conductivity at least three orders of magnitude higher than the conductivity of the active polymer layer, and wherein disposing the first and second electrodes each comprises forming a layer from a composition comprising an intrinsically conductive polymer, a dopant, and a solvent; and removing the solvent from the layer to provide the electrode.

### BRIEF DESCRIPTION OF THE DRAWINGS

The following Figures are exemplary embodiments, wherein like elements are numbered alike and in which:
FIG. 1 shows a polymer-based device;
FIG. 2 is a graphical illustration of Current Density (J) vs. Voltage (V) for PEDOT:PSS resistive WORM memory device fabricated on a glass substrate;
FIG. 3A shows a schematic view of a flexible, all-PEDOT:PSS resistive memory device;
FIG. 3B shows an optical microscope image of top inkjet-printed PEDOT:PSS electrodes on a PET substrate;
FIG. 4 is a graphical illustration of Current Density (J) vs. Voltage (V) for PEDOT:PSS resistive WORM memory device with silver electrodes;
FIG. 5 is a schematic illustration of a comparative non-volatile, PEDOT:PSS based resistive memory device with Pt and Au as bottom and top electrodes, respectively;
FIG. 6 is a schematic illustration of a non-volatile, PEDOT:PSS based resistive memory device with highly conducting PEDOT:PSS (m-PEDOT) as the bottom and top electrode;
FIG. 7 is an actual photograph of a flexible memory device;
FIG. 8 is a graph of transmittance (percent, %) versus wavelength (nanometer, nm) showing a UV-Vis optical transmission spectra of the flexible device compared to the bare substrate in the range of 250-700 nm.
FIG. 9 is a photograph demonstrating the transparency of the final device;
FIG. 10 is a graph of current density J (Ampere per square centimeter, A/cm²) versus voltage V (Volt, V) which is a typical J-V curve for Pt/PEDOT:PSS/Au memory device measures in the voltage range of +2 to -2 V and compliance set at 10 mA, wherein the sweep direction is indicated by the labeled arrows;
FIG. 11A is a cross-sectional TEM image of the device depicting the amorphous PEDOT:PSS layer with a thickness about 40 nanometers (nm);
FIG. 11B is a cross-sectional STEM image showing the filament composed of Au atoms connecting the top and bottom electrodes, wherein the encircled area "d" denotes the spot for EDX analysis;
FIG. 12 is a graph of intensity (counts) versus energy (kiloelectron volt, keV) which is a spot EDX spectrum obtained from the encircled area showing Au M and Au Lα peaks at 2.12 and 9.7 keV, respectively;
FIG. 13A is a graph of current density J (Ampere per square centimeter, A/cm²) versus voltage V (Volt, V) showing typical J-V characteristics of all-PEDOT resistive memory showing WORM behavior;
FIG. 13B is a graph of current density J (Ampere per square centimeter, A/cm²) versus voltage V (Volt, V) showing J-V behavior of the devices measured after 3 months of storage in ambient air demonstrating negligible deterioration in device performance;
FIG. 13C is a graph showing a comparison of the ON/OFF ratio for fresh and stored devices;
FIG. 13D is a graph of current density J (Ampere per square centimeter, A/cm²) versus voltage V (Volt, V) showing the retention test measurement for fresh and stored devices;
FIG. 14A is a GIWAXS patterns of the PEDOT thin film;
FIG. 14B is a GIWAXS patterns of the m-PEDOT thin film with the scale bar shown on the side;
FIG. 15 is a graph of intensity (arbitrary unit, a. u.) versus Qz/nm⁻¹ showing the intensity integration along the Q_{z} direction for the two films indicating peaks originating from the π-π stacking and the interaction from the polymer backbone;
FIG. 16A showing the 0.25 µm x 0.25 µm AFM phase image of m-PEDOT film spun on PET;
FIG. 16B showing the 0.25 µm x 0.25 µm AFM phase image of PEDOT spun on m-PEDOT showing conducting PEDOT domains as bright, elongated features; and
FIG. 16C showing the 0.25 µm x 0.25 µm AFM phase image of the PEDOT spun on a metal substrate, Pt showing a granular morphology.

### DETAILED DESCRIPTION OF THE INVENTION

The present disclosure demonstrates for the first time the use of a single polymer material to fabricate the entire resistive memory device. The inventors hereof surprisingly found that certain polymers, such as poly(3,4-ethylenedioxythiophene):poly(styrene sulfonic acid) [PEDOT:PSS], can act simultaneously as electrodes and as the material for the active polymer layer for electronic devices.

The polymer-based devices are particularly useful in the manufacture of electric devices fabricated on organic polymer substrates, as all the electrodes and the active polymer layer can advantageously be spin casted, which allows processing at low temperatures. The disclosed device structure has several advantages including ease of fabrication, transparency, flexibility, low voltage operation, and compatibility with roll-to-roll large-scale production.

Surprisingly, Applicants found that the polymer-based devices of the disclosure show typical WORM memory behavior and exhibit excellent performance with high ON/OFF ratios at low read voltages. The high ON/OFF ratio suggests longer data retention capabilities and lower possibilities of data misread in such devices. The low voltage operation makes the devices attractive for portable applications.

Generally, the polymer-based devices described herein comprise a substrate; a first electrode disposed on the substrate; an active polymer layer disposed on and in contact with the first electrode; and a second electrode disposed on and in contact with the active polymer layer, wherein the first and the second electrodes are organic electrodes comprising a doped electroconductive organic polymer, the active polymer layer comprises the electroconductive organic polymer of the first and the second electrodes, and the first and the second electrodes have conductivity at least three orders of magnitude higher than the conductivity of the active polymer layer.

Any substrate can be used in the polymer-based device, including silicon, glass, quartz, fused silica, plastic, banknotes, paper, and textile, and the like. In an embodiment, the substrate is flexible. Flexible substrates generally include polymers, both natural (e.g., paper or cloth) and synthetic, in particular thermoplastic polymers such as poly(carbonate), poly(ester)s such as poly(ethylene terephthalate), poly(ethylene naphthalate), poly(ether ether ketone), poly(ethersulfone), poly(etherimide), poly(imide), poly(norbornene), copolymers of the foregoing polymers, and the like. The substrate can be transparent and/or flexible. A specific substrate is poly(etherimide), for example the poly(etherimide)s from Sabic Innovative Plastics under the trade name ULTEM^{®}. Another specific substrate is polyethylene terephthalate.

The organic electrode comprises a doped electroconductive organic polymer, which comprises an intrinsically conductive organic polymer and a dopant that increases the electrical conductivity of the intrinsically conductive organic polymer. Any intrinsically conductive organic polymer can be used, provided that it can be doped to provide the desired conductivity. "Conductive organic polymers as used herein include electrically conducting or semiconducting polymers. Such polymers generally have (poly)-conjugated n-electron systems (e.g., double bonds, aromatic or heteroaromatic rings, or triple bonds) with conductive properties that are not influenced by environmental factors such as relative humidity. Useful intrinsically conductive organic polymers can have a resistivity of 10⁷ ohm-cm or less, 10⁶ ohm-cm or less, or 10⁵ ohm-cm or less. Intrinsically conductive organic polymers containing all-carbon aromatic rings can be, for example, poly(phenylene), poly(naphthalene), poly(azulene), poly(fluorene), poly(pyrene), or their copolymers. Intrinsically conductive organic polymers with a nitrogen-containing aromatic ring can be, for example, poly(pyrrole), poly(carbazole), poly(indole), poly(azepine), or their copolymers. Intrinsically conductive organic polymers with a sulfur-containing aromatic ring can be, for example, poly(thiophene), poly(3,4-ethylenedioxythiophene), or their copolymers. Other intrinsically conductive organic polymers can be, for example, poly(aniline) ("PANI"), poly(p-phenylene-sulfide), poly(acetylene), poly(p-phenylene vinylene), or their copolymers. Combinations comprising any one or more of the foregoing intrinsically conductive organic polymers can be used. The intrinsically conductive organic polymer used in the polymer based devices of the disclosure can be poly(3,4-ethylenedioxythiophene)-poly(styrenesulfonate) ("PEDOT-PSS").

To increase the conductivity of the intrinsically conductive organic polymers, the polymers are doped with a doping material ("dopant") that provides an increase in conductivity that is equal to or greater than three orders of magnitude relative to the conductivity of the undoped intrinsically conductive organic polymer. It has unexpectedly been found that using doped polymer improves the conductivity sufficiently relative to the undoped polymer that a device can be fabricated from a single polymer material with the doped polymer acts as the electrodes and the undoped polymer acts as the active polymer layer.

Generally, doping materials can be any organic compound effective to increase the conductivity of the intrinsically conductive organic polymer to the desired degree without significantly adversely affecting the desired properties of the intrinsically conductive polymer, for example, flexibility, heat resistance, transparency, cost, ease of processing, and the like. In addition, it is useful for the dopant to have a boiling point of greater than or equal to 120°C, or greater than or equal to 150°C to facilitate removal of water during manufacture of the devices. It is also useful for the dopant to be a liquid at doping temperature (e.g., 10 to 50°C, preferably 25°C) or miscible with a solution of the intrinsically conductive organic polymer and water. For example, the dopant can be ethylene glycol, 2-butanone, dimethylsulfoxide ("DMSO"), dimethylformamide ("DMF"), glycerol, sorbitol, hexamethylphosphoramide, graphene, and the like, or a combination comprising at least one of the foregoing dopants.

The dopant is used in an amount effective to increase the conductivity of the intrinsically conductive organic polymer by at least three orders of magnitude or more, or four orders of magnitude or more, up to five orders of magnitude. For example, the dopant can be present in the doped electroconductive polymer in an amount of 0.1 to 10 wt.%, based on the weight of the intrinsically conductive organic polymer, preferably, 0.5 to 10 wt.%, 1.0 to 10 wt.%, 2.0 wt.% to 9.0 wt.%, 3.0 to 8.0 wt.%, 4.0 wt.% to 7.0 wt.%, or 5.0 to 6.0 wt.%.

The doped electroconductive organic polymer can further comprise various additives known in the art to adjust the properties of the polymers, provided that such additives do not significantly adversely affect the desired properties of the polymers. Examples of such additives include low-molecular weight and oligomeric organic semiconductor materials, thermal curing agents, plasticizers, coupling agents, dyes, flame retardants, wetting agents, dispersants, fillers, viscosity modifiers, and photosensitive monomers, each of which can be present in amounts known in the art, for example 0.01 to 10 wt.%, or 0.01 to 1 wt.%, each based on the total weight of the doped electroconductive organic polymer. In an embodiment the total amount of additive is 0.01 to 10 wt.%, or 0.01 to 1 wt.%, each based on the total weight of the doped electroconductive organic polymer. In another embodiment, no or substantially no additive is present. Examples of low molecular weight and oligomeric organic semiconductor materials include anthracene, tetracene, pentacene, oligothiophene, melocyanine, copper phthalocyanine, perylene, rubrene, coronene, anthradithiophene, and the like.

The doped electroconductive organic polymer can have a conductivity of 900 Siemens/centimeter (S/cm) or greater. For example, the conductivity of the doped electroconductive polymer can be 1000 S/cm or greater, 1200 S/cm or greater, 1300 S/cm or greater, 1400 S/cm or greater, up to 2000 S/cm. Alternatively, the doped electroconductive organic polymer can have a conductivity of less than 900 S/cm. In each of the foregoing instances the conductivity is measured on a film having a thickness of 65 nm, a film having a thickness of 40 nm, or a film having a thickness of 10 nm. Thus, it is to be understood that such conductivities can be obtained for films having a thickness of 5 to 200 nm for example, preferably 10 to 150 nm, 20 to 100 nm, 25 to 90 nm, 60 to 80 nm, or 10 to 40 nm. Alternatively, or in addition, the doped electroconductive organic polymer can have a resistivity of 1x10⁵ ohm-cm or less, 1x10⁴ ohm-cm or less, or 1x10³ ohm-cm or less. Resistivities as low as 100 ohm-cm can be achieved at the foregoing thicknesses, for example 65 nm, 40 nm, or a film having a thickness of 10 nm.

Advantageously, the active polymer layer can comprise the same polymer material that is used for the electrodes except that the polymer material for the active polymer layer is not doped with the same dopant in amounts used in the electrodes so that the conductivity of the electrodes is at least three orders of magnitude higher than the conductivity of the active polymer layer. It is appreciated that the active polymer layer can contain small amounts of dopants. As long as the conductivity of the electrodes is three orders of magnitude higher than the conductivity of the active polymer layer, then a working polymer-based device can be manufactured.

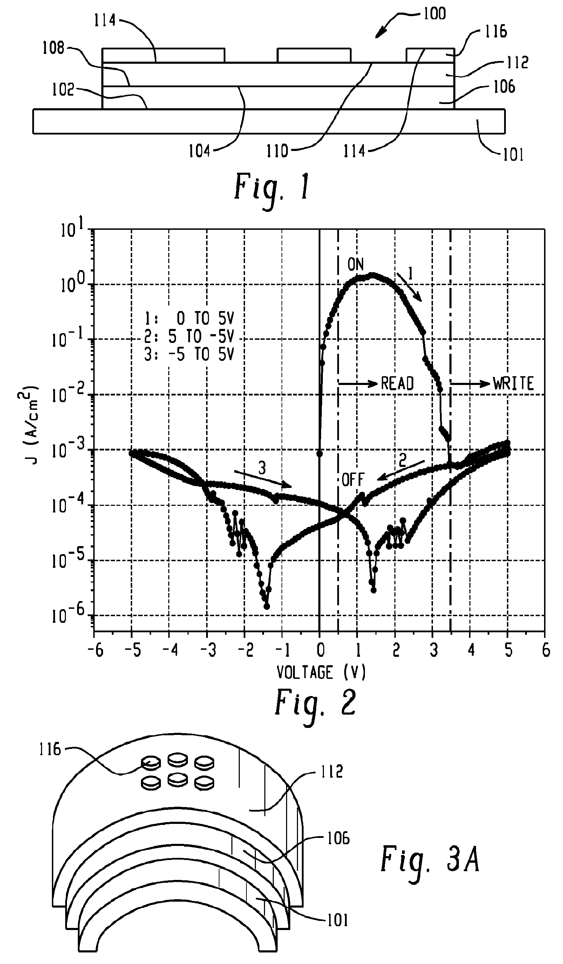

As used herein, "disposed on" means that an element is in contact with another element, and that each element may or may not be coextensive. "In contact with" means that an element may be in full or partial contact with another element. Thus, the substrate 101 can be coextensive with the electrode 106 (not shown) or not coextensive, as shown in FIG. 1. However, second side 104 of electrode 106 is in full or partial (not shown) contact with a first side 108 of ferroelectric layer 112; and the second side 110 of active polymer layer 112 is in full or partial contact (not shown) with a first side 114 of second electrode 116.

Electrodes 106, 116 are organic electrodes comprising a doped electroconductive organic polymer comprising an intrinsically conductive organic polymer and a dopant in an amount effective to increase the electroconductivity of the intrinsically conductive organic polymer. The organic electrode can have a resistivity of 1x10⁵ ohm-cm or less, 1x10⁴ ohm-cm or less, or 1x10³ ohm-cm or less. Resistivities as low as 100 ohm-cm can be achieved. Active polymer layer 112 can be organic containing the same electroconductive organic polymer in the electrodes. In an embodiment, both electrodes 106, 116 and active polymer layer 112 as well as substrate 101 are organic.

It is appreciated that the first electrode or the second electrode or both can comprise a printed pattern. An exemplary printed pattern comprises continuous lines. Advantageously, the lines do not intersect. In some embodiments, the lines of the first and second electrodes are parallel within the electrode, and the lines of the first and second electrodes are perpendicular. The lines can have a length of 0.1 to 10 cm, 0.5 to 5 cm, or 1 to 4 cm. The width of the lines varies depending on the application and can be 1 µm to 200 µm, 10 to 150 µm, or 25 to 100 µm. The thickness of the lines can be 5 to 1000 nm, 10 to 1000 nm, or 5 to 500 nm.

In a specific embodiment, the polymer-based devices are thin film polymer-based device, in particular flexible polymer-based thin film devices, where each of the electrodes, and the active polymer layers has a thickness of 5 to 1000 nm, where the thickness is the dimension perpendicular to the surfaces of the substrate. As described above, the electrodes and the active polymer layers may be continuous or discontinuous. In the case of discontinuous layer, this means that each portion of the layer is separated from its adjacent portions. In other words, a discontinuous layer is an ensemble of spaced apart, discrete elements. A continuous layer may not necessarily completely cover a surface (it may have openings or vias through the layer). The electrode is a doped electroconductive organic polymer, and the electrode is disposed on and in contact with at least one surface of the active polymer layer.

For example, the thickness of each layer in a thin film device can be 5 to 1000 nm, 10 to 1000 nm, 5 to 500 nm, 10 to 500 nm, 5 to 200 nm, 10 to 200 nm, 5 to 100, 5 to 120 nm, 10 to 100, or 60 to 120 nm. While the thickness of each component can vary depending on the application, an organic electrode can have a thickness of 5 to 150 nm, 10 to 120 nm, 15 to 1000 nm, 20 to 90 nm, or 30 to 80 nm. The active polymer layer can have a thickness of 5 to 100 nm, 10 to 90 nm, 15 to 80 nm, 20 to 70 nm, or 30 to 60 nm. A total thickness of the device can be, for example, 20 to 5000 nm, or 30 to 3000 nm, 40 to 2000 nm or 50 to 1000 nm.

A variety of devices can accordingly be manufactured, for example memory devices, non-volatile memory devices, capacitors, diodes, or electric devices comprising at least one of the foregoing. The polymer-based devices described can be positioned in layers of thin films to form larger assemblies, for example integrated circuit boards.

Applicants found that the polymer-based devices of the disclosure show typical WORM memory behavior and exhibit excellent performance with high ON/OFF ratios at low read voltages. The high ON/OFF ratio suggests longer data retention capabilities and lower possibilities of data misread in such devices. The low voltage operation makes the devices attractive for portable applications.

The devices are typically in a low resistance state at low voltages, for example less than 2 V. This is the ON state of the devices and can be attributed to a "1" state of the memory. Applying a relative high voltage, for example a voltage more than 3.5 V, writes the device into a high resistance state which is the OFF state of the memory. After the writing step, the current from the devices is low (for example <10⁻³ A/cm²) and can be considered as the "0" state of the memory. At this stage, the devices are considered set and can no longer be re-written, edited or tampered with, emphasizing its use for security, data-protection applications. The information stored in the device can be accessed/read many times at low voltages, for example less than 1 V. In a preferred embodiment, the polymer-based devices have low write voltages (less than 3V), high ON/OFF ratio (greater than 10³), good retention characteristics (greater than 10,000 seconds) and stability in ambient storage (greater than 3 months). In some embodiments, the ON/OFF ratio is equal to or greater than about 10⁴.

The above-described devices and device components can be manufactured by disposing a first electrode on a surface of a substrate, disposing an active polymer layer on the side of the electrode opposite the substrate; and disposing a second electrode on the active polymer layer, wherein the first and the second electrodes can comprise a doped electroconducting organic polymer, and the active polymer layer comprises the electroconductive organic polymer of the first and the second electrodes, provided that the first and second electrodes have conductivity at least three orders of magnitude higher than the conductivity of the active polymer layer.

Optionally, the substrate can be subjected to various treatments prior to depositing the first electrode, for example, cleaning, a primer treatment, corona treatment, etching treatment, plasma treatment, and the like. For example, the substrate can be cleaned with solvents specific for known contaminants, for example release agents. Exemplary solvents for use with polymer substrates include deionized water, alcohols such as methanol, ethanol, and isopropanol, acetone, ethyl acetate, chlorinated hydrocarbons such as dichloromethane, and the like, or a combination comprising at least one of the foregoing solvents. Washing can also be sequential, for example acetone, followed by isopropanol, followed by water. Substrate cleaning usually takes place prior to device fabrication, but can also be conducted at intermediate stages.

Alternatively, or in addition, the substrates can be corona or plasma treated, for example to render their surface hydrophilic, thus promoting charge transfer and better bonding with the electrode. Treatment of the surface can be, for example by exposing a surface of the substrate to an oxygen plasma or UV ozone or coating by self- assembled monolayers ("SAMs") such as 16-mercaptohexadecanoic acid to render substrate hydrophilic.

After preparation of the surface of the substrate, and deposition of any intervening layers (e.g., a primer or adhesive), a first electrode is deposited on the substrate, followed by the active polymer layer, followed by the second electrode. The electrodes can be pre-formed and then transferred to the substrate, or formed directly on the preceding layer. Direct formation is generally preferred, particularly in thin film devices.

Deposition of the active polymer layer can further be accomplished by means known in the art, for example sputtering, CVD, or deposition of a sol-gel for inorganic materials. Thin films of active polymers can be produced by solution spin coating or dip casting, Langmuir-Blodgett ("LB") monolayer growth, and vapor deposition polymerization, ink-jet printing, gravure printing, roll-to-roll processing, drop casting, spraying, and the like. These deposition processes can be performed at temperatures below 200° C, which allows their use with organic substrates. Films with various thicknesses can be obtained by controlling the spin conditions, solution concentration, and/or using a multiple coating process. For example, spin-coating can be at 100 to 6000 rpm, 500 to 5000 rpm, 1000 to 4000 rpm, 1500 to 3000 rpm, or 2000 to 2500 rpm for a period of, for example 5 to 120 seconds, preferably, 15 to 90 seconds, more preferably, 20 to 70 second, forming the active polymer layer.

The polymer-based film can be annealed to remove the residual solvent or improve the crystallinity. For example, the films can be annealed at 80 to 150°C under vacuum. This process can obtain films with a thickness between 50 nm to more than 1 micrometer.

Similarly, deposition of the doped electroconductive organic polymer can be achieved by coating methods such as solution spin coating, solution casting, ink-jet printing, drop casting, gravure printing, roll-to-roll processing, and the like. In an embodiment, deposition is by spin-casting a solution of the intrinsically conductive organic polymer, dopant, and a solvent at, for example 100 to 6000 rpm, 500 to 5000 rpm, 1000 to 4000 rpm, 1500 to 3000 rpm, or 2000 to 2500 rpm for a period of, for example 5 to 60 seconds, 15 to 45 seconds, or 20 to 40 seconds to form a layer of the doped electroconductive organic polymer. Alternatively, the doped electroconductive organic polymer can be deposited in a pattern, for example by lithography, ink-jet printing such as drop-on-demand piezoelectric ink-jet printing technique, or drop casting, to form a patterned layer of the doped electroconductive organic polymer.

Forming the layer is followed by annealing the layer for a time and at a temperature effective to remove residual solvent in which the doped electroconductive organic polymer is dissolved, typically water or a combination of water and another solvent. The temperature used for annealing may be constant or may increase throughout the annealing process, for example may be maintained at a fixed temperature above the glass transition temperature ("T-Tg").

The electrode can be further patterned before or after heat annealing, for example by reactive ion etch ("RIE"). For example, in reactive ion etching, a mask containing the desired electrode pattern is placed on top of the electrode film and a highly directional flux of energetic, reactive ions is delivered to the material surface. In doing so, a precisely controlled patterning of the electrode film layer occurs as un-masked sample is etched away by the reactive ions.

The polymer-based devices such as those made from doped poly(3,4-ethylenedioxythiophene) poly(styrenesulfonate) ("PEDOT/PSS"), doped poly(aniline) ("PANI"), and the like as the electrodes and undoped PEDOT/PSS, PANI, and the like, as the active polymer layer, can be manufactured as memory devices, for example WORM, capacitors, transistors, diodes, or electric devices comprising at least one of the foregoing due to flexibility, transparency, low-temperature processability, high ON/OFF ratios at low read voltages, and the potential they offer for large-area and low-cost deposition techniques such as spin coating and ink-jet printing. A wide variety of flexible substrates can be used, including synthetic polymers, paper, cloth, or other natural substances, which allows manufacture of a correspondingly wide variety of articles comprising the polymer-based devices. Thus, articles as diverse as banknotes, clothing, credit cards, debit cards, security devices, or foodstuffs can now be provided with electrical devices such as memory devices, capacitors, sensors and the like.

The following examples are merely illustrative of the devices and methods disclosed herein and are not intended to limit the scope hereof.

### EXAMPLES

In some examples, the morphology of doped and undoped PEDOT:PSS thin films was studied using an Atomic Force Microscope (AFM, Agilent 5400). Grazing Incident Wide-angle X-ray Scattering (GIWAXS) measurements were performed at D-line, Cornell High Energy Synchrotron Source (CHESS) in Cornell University. A wide band-pass (1.47 %) X-ray with wavelength of 1.167Å was shone on the samples with a grazing incidence angle of 0.15°. A 50×50 mm CCD detector (Medoptics) with a pixel size of 46.9 µm was placed at a distance of 95 mm from the samples. A 1.5 mm-wide tantalum rod was used to block the intense scattering in small angle area. The exposure time was 1 second. The samples for cross section TEM analysis were prepared by focused ion beam (FIB, Helios 400s, FEI) with lift-out method. The lamellar was thinned with a Ga ion beam (30 kV, 0.28 nA) and cleaned at 2 kV and 47 pA. A Titan ST 300 kV was used for high resolution transmission electron microscopy (HRTEM) and STEM imaging. The electrical characterization including retention tests was done in ambient air using a Keithley 4200 Semiconductor Parameter Analyzer.

### Example 1. Device Fabricated on Glass Substrate

Glass substrates were cleaned by ultrasonication in acetone, isopropanol, and DI (deionized) water. Further cleaning of the surface was done by treating the glass substrates with O₂ plasma for 1 minute at low RF powers of approximately 10 W. PEDOT: PSS under the brand name Clevios™ PH 1000 from Heraeus was doped with approximately 5 wt.% DMSO to obtain a maximum conductivity of about 900 S/cm. The doped PEDOT: PSS was spun on the glass substrates at 500 rpm for 5 seconds followed by a spinning at 2000 rpm for 30 seconds. The thickness of the bottom electrodes was approximately 60 nm. The bottom layer was dried at 120 °C for 1 hour. Following this, the active polymer layer i.e. undoped/pristine PEDOT: PSS was spun on the bottom electrode at similar conditions. Finally doped PEDOT: PSS was ink-jet printed to form the top electrode. A MicroFab JetlLab II piezoelectric ink-jet printer was used to ink-jet print the top doped PEDOT: PSS electrodes.

The graphical illustration of Current Density (J) vs. Voltage (V) for the device is shown in FIG. 2. As shown in FIG. 2 in the high current densities (about 1 A/cm²), the all polymer PEDOT:PSS memory device is in a low resistance state at voltages of less than 2. This is the ON state of the device and can be attributed to a "1" state of the memory. Applying a voltage more than 3.5 V writes the device into a high resistance state which is the OFF state of the memory. This process can be seen in the first sweep to a virgin device from 0 to 5 V in FIG. 2. After the writing step, the current from the device is as low as <10⁻³ A/cm² and can be considered as the "0" state of the memory. The device is set now and can no longer be re-written, edited or tampered with. The information stored in the device can be accessed/read many times at voltages lower than 1 V. This is shown by sweeping the device from 5 to -5 V and back, as seen in FIG. 2.

### Example 2. Device Fabricated on Polyethylene Terephthalate Substrates

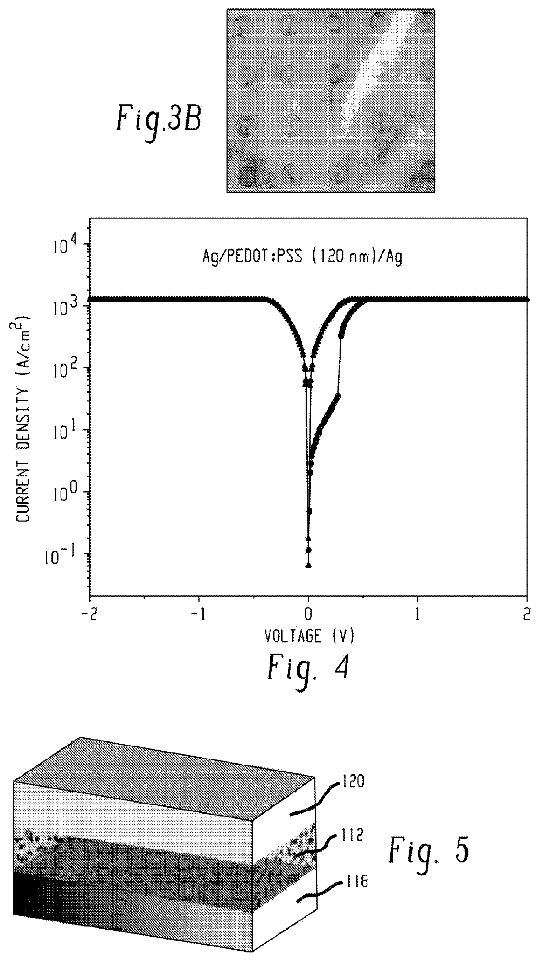

Polyethylene terephthalate ("SABIC") substrates were cleaned by ultrasonication in acetone, isopropanol, and DI water. Further cleaning of the surface was done by treating the PET substrates with O₂ plasma for 1 minute at low RF powers of approximately 10 W. PEDOT: PSS under the brand name Clevios™ PH 1000 from Heraeus was doped with approximately 5 wt.% DMSO to obtain a maximum conductivity of about 900 S/cm. The doped PEDOT: PSS was spun on the PET substrates at 500 rpm for 5 seconds followed by a spinning at 2000 rpm for 30 seconds. The thickness of the bottom electrodes was about 60 nm. The bottom layer was dried at 120 °C for 1 hour. Following this, the active polymer layer i.e. undoped/pristine PEDOT: PSS was spun on the bottom electrode at similar conditions. Finally doped PEDOT: PSS was ink-jet printed to form the top electrode. A MicroFab JetlLab II piezoelectric ink-jet printer was used to inkjet-print the top doped PEDOT: PSS electrodes. FIG. 3A shows a schematic of the completed all-polymer, flexible and transparent polymer-based device, while FIG. 3B shows a microscope image of the ink-jet printed top electrodes.

### Comparative Example 3. WORM Memory Having Silver Electrodes

FIG. 4 shows a WORM memory behavior where PEDOT: PSS is the active polymer layer and silver (Ag) metal is used as electrodes. The device shows an opposite behavior to the all polymer PEDOT: PSS memory, but with a WORM memory behavior nonetheless. The device is in a high resistance state ("OFF") with low current density at low voltages (< 0.2 V). This can be considered as the OFF state or "0" state of the memory. The device can be written into a low resistance state or turned ON at voltages about 0.3 V. This is permanent and the device remains in low resistance state with high current density, as seen from voltage sweeps from 1 to -1 V and back. The device shows low voltage operation and can be read at 0.2 V but with low ON/OFF ratios about (< 10²) which is lower than the all PEDOT: PSS resistive WORM memory.

### Comparative Example 4. WORM Memory Having Gold and Platinum Electrodes

A metal/PEDOT:PSS/metal resistive memory device, in which gold (Au) electrode 120 and platinum (Pt) electrode 118 were used for the top and bottom electrodes, respectively, have been fabricated and is shown schematically in FIG. 5.

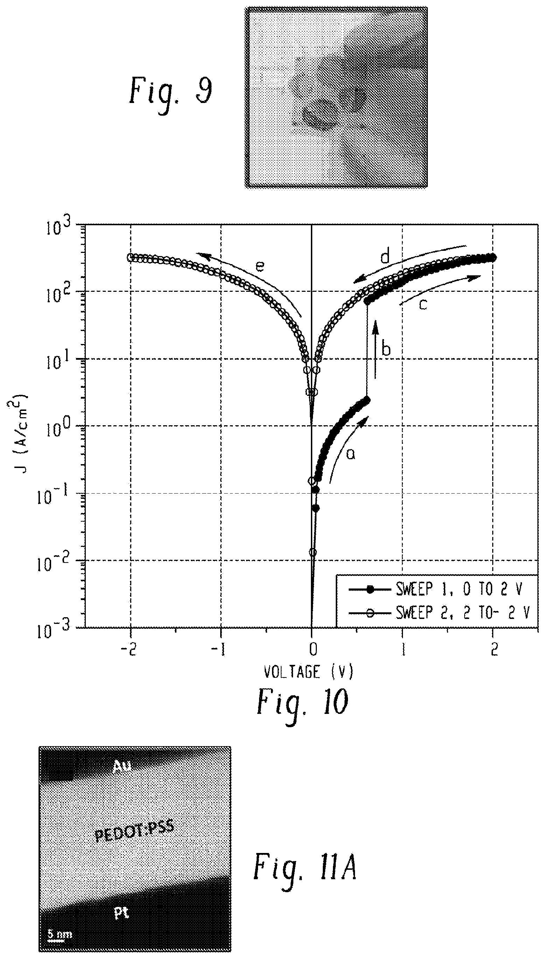

FIG. 10 shows a characteristic current density-voltage (J-V) plot for a unipolar, bistable WORM memory device with metal electrodes. The electrical characterization of these memory devices was done with the bottom electrode grounded and a sweeping bias applied to the top electrode. For all virgin devices, the current in the active PEDOT:PSS layer under positive bias increases slowly at low voltage followed by an abrupt increase in current density to 100 A/cm² at around 0.6 V, beyond which a saturation in the leakage current density is reached. This is shown in the sequence denoted by a → b → c in FIG. 10. This sharp transition from a high resistance state ("HRS") to a low resistance state ("LRS") can be considered as the "WRITE" step in such memory devices. Subsequent voltage sweeps from 2 to -2 V, denoted by d → e, do not change the resistance state of the cell implying that the data can only be "READ" once it has been written. Such a behavior in PEDOT:PSS resistive memory may be attributed to the formation of conducting PEDOT + filament through charge-induced oxidation. However, in this case, the formation of a conducting PEDOT + filament through charge-induced oxidation is unlikely because (a) it cannot explain the sharp increase in current density to 100 A/cm², and (b) despite voltage sweeps in the opposite polarity, the resistance state could not be changed. The irreversibility of the process indicates that the sudden rise in current at point b is due to the formation of a metal filament, likely caused by the diffusion of Au atoms under the applied field, from the top electrode to the bottom electrode.

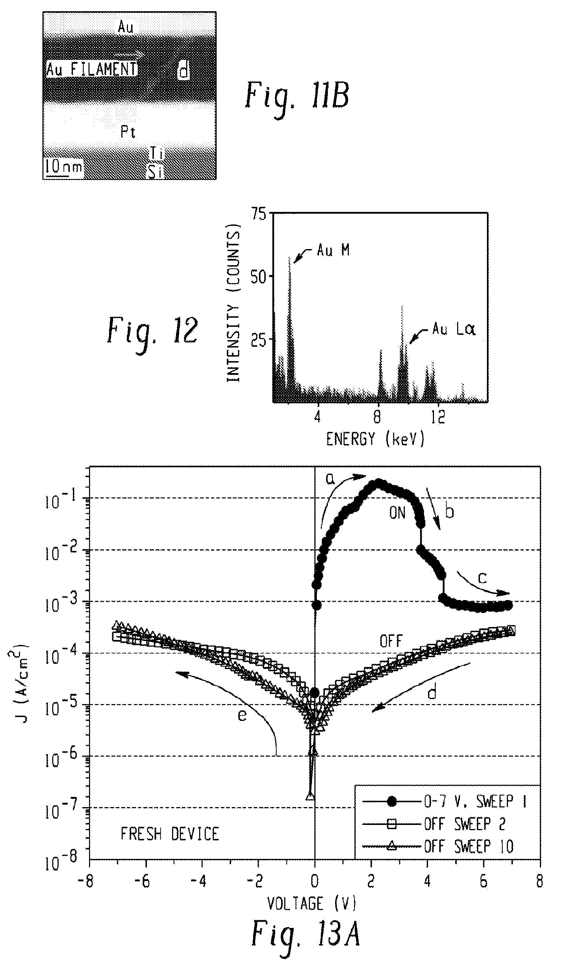

FIG. 11A shows a cross-sectional TEM image of the device Au/PEDOT:PSS/Pt stack before the switching voltages were applied (HRS state). It is noted that the PEDOT:PSS film (38 nm) shows an amorphous nature and no evidence of any metal diffusion. In contrast, FIG. 11B shows a device which has been written to the low resistance state by application of a 2-V positive bias. It is also noted that a filament of metal is clearly evident in the device after it has been written to the LRS. The diffused Au atoms in the amorphous polymer film form a bridge connecting the top and bottom electrode, resulting in the Ohmic behavior of the memory in the LRS state. To investigate the composition of this filament, cross-sectional Scanning Tunneling Electron Microscopy ("STEM") was performed for a memory cell in the LRS state and is shown in FIG. 11B. High-Angle Annular Dark-Field ("HAADF") imaging using STEM mode provides sensitive imaging of heavy elements due to Z-contrast. The analysis in FIG. 11B clearly shows a continuous filament, about 45 nm long and 4 - 5 nm wide, within the PEDOT:PSS film. Several instances of such connecting metal filaments were found within the same device. A spot Energy Dispersive X-Ray ("EDX") analysis of the metal filament, shown in FIG. 12 further confirms the presence of Au atoms. Under the STEM mode, the spot size can be controlled to very small dimensions, typically 0.5 to 1 nm, which rules out the possibility of collecting signals from the top Au electrode. The peaks occurring at 2.12 keV and 9.71 keV are identified as Au M and Au Lα, respectively. Simultaneously, an EDX analysis of the PEDOT:PSS adjacent to the Au filament was performed which showed no Au signal. This further confirmed that no signal was coming for the Au electrode. It is important to mention here that though other groups have reported "fusing-out" or "rupturing" of the metal filament under opposite voltage or high current, this reversible behavior was not observed here. The current-voltage ("J-V") characteristics of Au/PEDOT:PSS/Pt devices under a sweeping bias of ± 4 V was also measured. The current levels remained high and saturated at the compliance level of the measurement instrument indicating that the devices do not switch to the HRS (high resistance state) or turn OFF even at higher bias or larger current flow. Instead, it was observed that the Au electrode delaminated at higher bias (about 4V), possibly due to Joule heating. This is consistent with the suggestion that the memory effect in the case of the device with gold electrode is not real; and devices cannot be used for practical applications. Though these devices exhibit non-volatility, bistability, and a WORM behavior, it can be argued that the switching mechanism (metal-filament formation) is an artifact of Au diffusion process rather than a characteristic of PEDOT:PSS itself. This observation may also explain why there are large variations in the reported behavior of PEDOT:PSS resistive memories that use metal electrodes, particularly Au. It is known that partial or full diffusion of the Au electrode through the active polymer layer can mask the true behavior of the device and produce such variation. To study the actual memory behavior of PEDOT:PSS, the possibility that metal-filament formation will mask the true resistive switching behavior of the PEDOT:PSS active layer itself should be eliminated. Therefore, all-polymer, metal-free PEDOT:PSS resistive memory devices, where metals were replaced with conductive polymer contacts were made as described below.

### Example 5. All-polymer Device Fabricated on Polyethylene Terephthalate Substrates

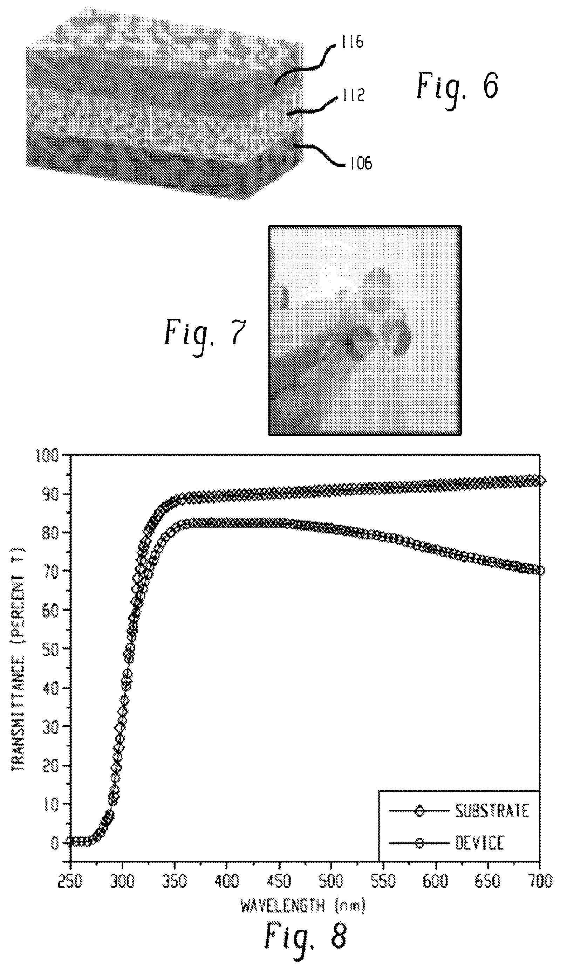

As shown in FIG. 6, conducting electrodes were made using modified PEDOT:PSS ("m-PEDOT"), instead of metals. The metal electrodes in the WORM memory device described in Comparative Example 4 were replaced with modified PEDOT:PSS to which 4 wt.% dimethyl sulfoxide had been added. The device cross-section of an all-PEDOT:PSS memory device on a PET substrate is illustrated schematically in FIG. 3A, and the texture of this device is shown schematically in FIG. 6, and described in more detail below. To make the all-polymer device, a single layer of m-PEDOT was spun-cast on pre-cleaned substrates, followed by annealing on a hotplate at 120 °C for 1 hour to form the bottom electrode. Once completely baked, the layer became insoluble, allowing spin-casting of the subsequent active polymer layer, PEDOT. To confirm that there is no re-dissolution of the underlying PEDOT:PSS layer, a thin film of PEDOT:PSS spun on a Si-wafer was immersed in deionized ("DI") water for 30 min. PEDOT:PSS was used as an aqueous solution. A negligible difference in the thickness of the PEDOT:PSS film measured before and after immersion was found. After the active layer, a formulated m-PEDOT:PSS based ink was used to inkjet-print an array of top electrodes. The thicknesses measured using a Dektak profilometer for the bottom electrode, active layer and the top electrode are 30 ± 2 nm, 40 ± 2 nm and 90 ± 5 nm, respectively, confirmed by cross-sectional Transmission Electron Microscopy ("TEM").

An actual photograph of the device is shown in FIG. 7 where the flexibility of the substrate is demonstrated. FIG. 8 shows the UV-Visible optical transmission spectra of the bare plastic substrate and the full all-PEDOT:PSS device stack from wavelength, λ = 250 - 700 nm. The optical transmission only drops from 82 % to 76 % in the wavelength range of 350 nm - 600 nm. The excellent transparency of the final device stack is demonstrated in the actual photograph shown in FIG. 9.

The J-V characteristics of freshly prepared all-PEDOT:PSS resistive memory on a flexible PET substrate are shown in FIG. 13A. It is evident that no "forming" process was required to induce the memory behavior in these devices. The devices are typically in a low-resistance state ("LRS") at voltages below about 3 V. This state could be considered as the ON state of the memory. Applying a relatively high voltage, more than 3.5 V, writes the device into a HRS, which becomes the OFF state of the memory. After the writing step, the current from the devices is low (<10⁻³ A/cm²) and remains low up to ±7 V. At this stage, the devices are considered set and can no longer be re-written, edited or tampered with, emphasizing their potential use in security and data-protection applications. Also, the high I_{ON/OFF} ratio (> 3 x 10³) at low operating voltages suggests lower possibilities of data misread in such devices.

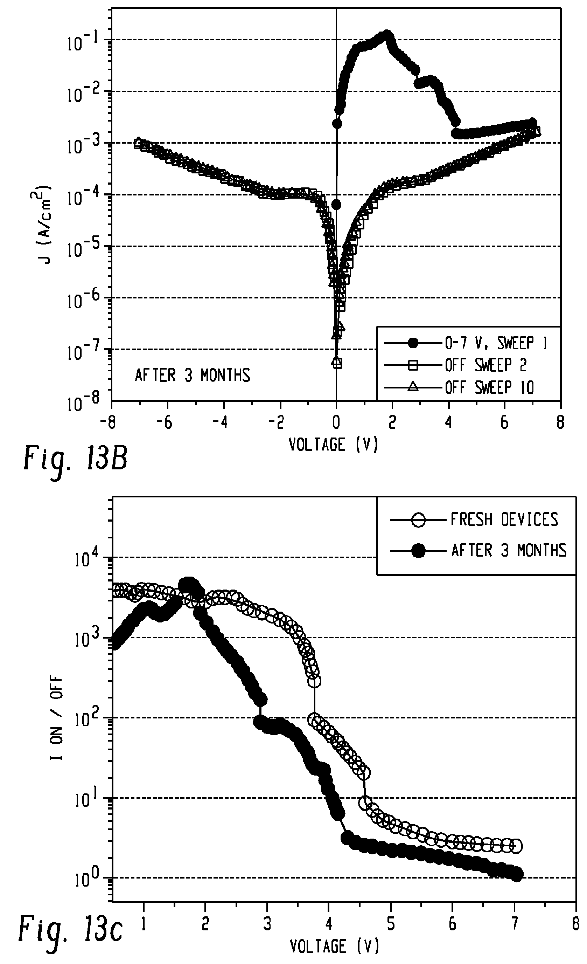

The information stored in these devices can be accessed or read many times using small voltages (e.g., 1 V or lower). After multiple voltage sweeps from 0 to ± 7 V (denoted by d → e), the device still remains in the HRS or the OFF state, demonstrating good electrical bistability. All the devices measured exhibit an irreversible transition from a conducting ("LRS") state to a non-conducting ("HRS") state at higher voltages. This irreversible and reproducible switching process is essential for memory components in practical circuits. The J-V characteristics of these devices were remeasured after 3 months of storage in ambient air, as shown in FIG. 13B. The switching characteristics and device performance are maintained, suggesting excellent stability of these all-PEDOT:PSS memory devices. FIG. 13C compares the I_{ON/OFF} ratio of devices measured immediately after fabrication (fresh) and after 3 months of storage. The slightly higher ION/OFF ratio for the aged devices in the low voltage regime (<2 V) can be attributed to the lower leakage current in the OFF state of the aged device, while the ON state current remains similar. In comparison, at higher voltages, the I_{ON/OFF} ratio for the aged devices declines at a faster rate than the fresh device, which could be attributed to the higher conductivity of the polymer thin film due to oxidation over time, which can also be seen in FIG. 13B.

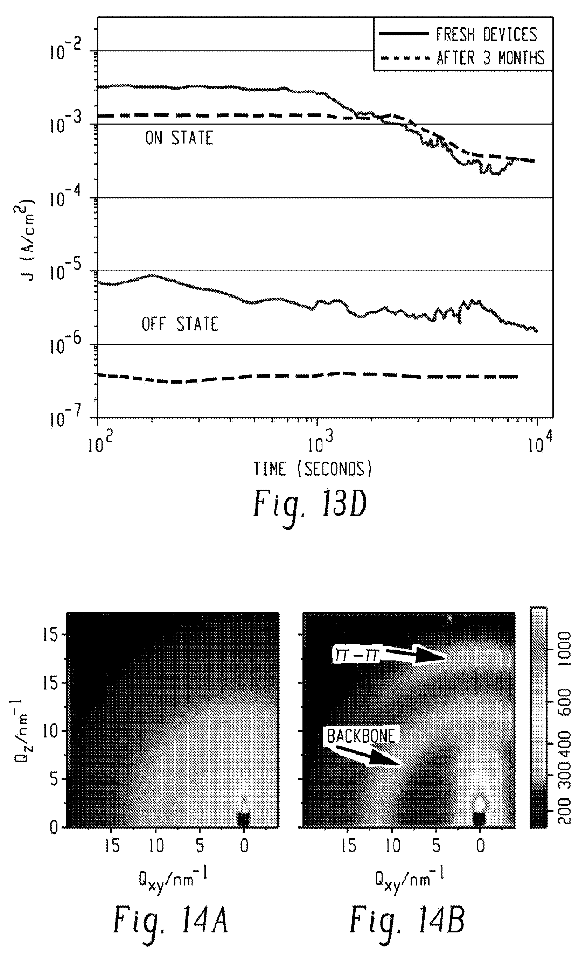

The retention characteristics of the PEDOT:PSS memory with polymer electrodes were also investigated. FIG. 13D shows the magnitude of the ON and OFF state currents measured as a function of time for 10,000 seconds. The ON state (LRS) current was measured at 0.5 V, prior to switching the device to the OFF state. In comparison, the OFF current was measured after switching the device to OFF state (HRS) by applying a high voltage. The device shows an ON/OFF ratio of 100, even after 10,000 secs, indicating excellent retention characteristics of these devices. For comparison, the retention properties of the all-polymer memory devices after 3 months of storage in ambient conditions was also measured, but no significant deterioration was observed for the current values in the ON state, as shown in FIG. 13D. After 3 months, the OFF state current is reduced by almost an order of magnitude, consistent with the J-V data shown in FIG. 13B.

The most widely reported switching mechanism for bistable polymeric resistive memory devices is based on filamentary conduction. There are generally two types of conductive filaments for polymeric systems, particularly involving PEDOT:PSS as the active layer. One is a metal filament which involves either a redox reaction or the diffusion of the electrode metal atoms under an applied electric field, and the other is a molecular filament mainly related to the oxidation and reduction of the PEDOT:PSS thin film. The morphology and crystallinity of m-PEDOT and PEDOT films using Grazing Incident Wide Angle X-Ray Scattering ("GIWAXS") and Atomic Force Microscopy ("AFM") was investigated. These results suggest that the ON to OFF switching behavior of devices with polymer electrodes may also be related to the morphological modifications of the PEDOT:PSS polymer films.

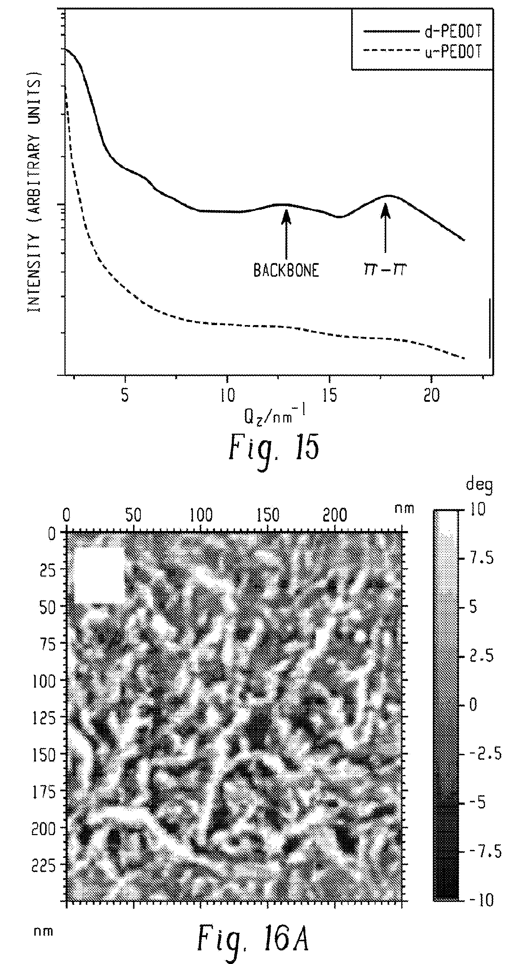

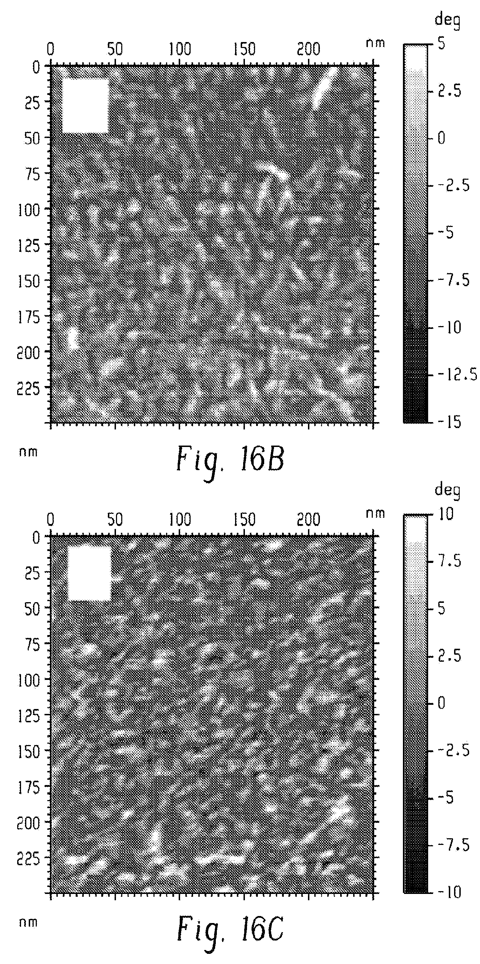

The GIWAXS patterns of PEDOT and m-PEDOT thin films are shown in FIG.s 14A and 14B, respectively. The m-PEDOT film shows better crystallinity as indicated by the stronger diffraction intensity from π-π stacking and the polymer backbone, compared to the PEDOT films. FIG. 15 compares the integrated intensity along the Q_{z} direction for both films. The two scattering peaks in the m-PEDOT film occurring at Q_{z}=12.4 and 17.7 nm⁻¹ (d spacing = 5.1 Å and 3.5 Å) correspond to the backbone interchain planar distance and the distance between the π-orbitals, respectively. At the molecular level, the increased π-π orbital interaction facilitates better charge transport, resulting in the higher conductivity of m-PEDOT films compared to the amorphous PEDOT films. The higher conductivity of m-PEDOT films can also be explained based on the morphology studied by tapping-mode AFM shown in FIG. 16A. In m-PEDOT, addition of high boiling point solvents like DMSO or diethylene glycol ("DEG") causes the excess PSS to phase-segregate into PSS-rich domains while the PEDOT grains merge together to form an interconnected network of conducting fibers (bright fibers in the phase image). The presence of highly conducting PEDOT fibers through which the charges can move freely leads to the high conductivity (> 900 S cm⁻¹) of the m-PEDOT film, rendering it suitable for use as an electrical contact.

The phase images of the PEDOT layer spun-cast on m-PEDOT film and Pt substrate are shown in FIG.s 16B and 16C, respectively. Unmodified PEDOT films spun on m-PEDOT layer show elongated features or grains of PEDOT dispersed in PSS matrix, similar to the underlying m-PEDOT film. This is in contrast to the granular morphology for PEDOT films grown on metal (Pt) substrates, as seen from FIG. 16C. It is believed that the fibrous morphology of the bottom m-PEDOT electrode film promotes preferential alignment of PEDOT chains at the interface forming a conducting path for the charges to freely move from the bottom electrode to the PEDOT active layer. This can also explain the normally ON state of the memory devices at low voltages, as noticed in the J-V characteristics. However, it is known that in the presence of a large applied electric field, the insulating PSS⁻ chains migrate towards the interface and prevent charge transport from the bottom electrode to the PEDOT⁺ fibers. This hindered charge transport results in a gradual drop in conductivity of the PEDOT:PSS film and consequently the current density is also reduced at high voltages. Further voltage sweeps result in low current response or the OFF state of these devices. The WORM memory devices with high voltages (± 12 V) to see the stability of the behavior have been characterized. This was to see if the PSS diffusion can be reversed and whether the devices can be turned back to the ON state. The current from all polymer memory devices remained low even at high voltages up to 12 V. Thus, any reversible behavior further confirming the stable WORM behavior of the polymer devices were not observed. This irreversible, field-induced change in the morphology defines the WORM behavior in PEDOT:PSS resistive memory devices.

The foregoing Examples show that, all-polymer, Write-Once-Read-Many times' resistive memory devices have been fabricated on flexible substrates using a single polymer, PEDOT:PSS. Spin-cast or inkjet-printed films of solvent-modified PEDOT:PSS are used as electrodes while the unmodified or as-is PEDOT:PSS is used as the semiconducting active layer. The all-polymer devices exhibit an irreversible but stable transition from a low resistance state (ON) to a high resistance state (OFF) at low voltages caused due to an electric field induced morphological rearrangement of PEDOT and PSS at the electrode interface. However, in the metal-PEDOT:PSS-metal devices, metal filament formation has been shown, switching the device from an initial high resistance state (OFF) to the low resistance state (ON). The all-PEDOT:PSS memory device has low write voltages (less than 3V), high ON/OFF ratio (greater than 10³), good retention characteristics (greater than 10,000 seconds) and stability in ambient storage (greater than 3 months).

In summary, in an embodiment, a polymer-based device comprises a substrate, preferably silicon, glass, quartz, fused silica, a polymer, a banknote, paper, or textile, even more preferably wherein the substrate is flexible; a first electrode disposed on the substrate; an active polymer layer disposed on and in contact with the first electrode; and a second electrode disposed on and in contact with the active polymer layer, wherein the first and the second electrodes are organic electrodes comprising a doped electroconductive organic polymer, preferably comprising an intrinsically conductive organic polymer (preferably wherein the intrinsically conductive organic polymer is poly(phenylene), poly(naphthalene), poly(azulene), poly(fluorene), poly(pyrene) poly(pyrrole), poly(carbazole), poly(indole), poly(azepine), poly(aniline) poly(thiophene), poly(3,4-ethylenedioxythiophene), poly(p-phenylene-sulfide), poly(acetylene), poly(p-phenylene vinylene), copolymers of the foregoing polymers, or a combination comprising at least one of the foregoing polymers or copolymers, even more preferably poly(3,4-ethylenedioxythiophene)-poly(styrenesulfonate), poly(aniline), poly(pyrrole), or a combination comprising at least one of the foregoing intrinsically conductive organic polymers) and a dopant (preferably present in an amount effective to increase the conductivity of the intrinsically conductive organic polymer by two orders of magnitude or more, more preferably wherein the dopant is an organic compound having a boiling point of 120°C or greater, and that is miscible with a solution of the intrinsically conductive organic polymer and water, most preferably wherein the dopant is ethylene glycol, 2-butanone, dimethylsulfoxide, dimethylformamide, glycerol, sorbitol, hexamethylphosphoramide, graphene or a combination comprising at least one of the foregoing dopants, specifically DMSO) in an amount effective to increase the electroconductivity of the intrinsically conductive organic polymer, preferably from 2.0 to 10.0 wt.% based on the weight of the intrinsically conductive organic polymer wherein the active polymer layer comprises poly(3,4-ethylenedioxythiophene)-poly(styrenesulfonate); and the first and second electrodes each comprises dimethylsulfoxide-doped poly(3,4-ethylenedioxythiophene)-poly(styrenesulfonate); wherein the active polymer layer comprises the electroconductive organic polymer of the first and the second electrodes, and the first and the second electrodes have a conductivity at least three orders of magnitude higher than the conductivity of the active polymer layer, preferably wherein the conductivity of the organic electrode is 900 Siemens/centimeter or greater measured at a thickness of 65 nm, or the conductivity of the organic electrode is less than 900 Siemens/centimeter measured at a thickness of 65 nm, and preferably wherein the resistivity of the organic electrode is 1x10⁵ ohm-cm or less. In any of the foregoing embodiments, the first electrode, the second electrode, or both, preferably have a thickness of 15 nm to 120 nm, wherein the first electrode, the second electrode, or both are patterned, and the device is flexible. The device is preferably a memory device, a capacitor, a transistor, or a diode.

In another embodiment, a method of making a polymer-based device comprises disposing a first electrode on a substrate; disposing an active polymer layer on the first electrode; and disposing a second electrode on the active polymer layer, wherein the first and the second electrodes are organic electrodes comprising a doped electroconductive organic polymer, preferably comprising an intrinsically conductive organic polymer (preferably wherein the intrinsically conductive organic polymer is poly(phenylene), poly(naphthalene), poly(azulene), poly(fluorene), poly(pyrene) poly(pyrrole), poly(carbazole), poly(indole), poly(azepine), poly(aniline) poly(thiophene), poly(3,4-ethylenedioxythiophene), poly(p-phenylene-sulfide), poly(acetylene), poly(p-phenylene vinylene), copolymers of the foregoing polymers, or a combination comprising at least one of the foregoing polymers or copolymers, even more preferably poly(3,4-ethylenedioxythiophene)-poly(styrenesulfonate), poly(aniline), poly(pyrrole), or a combination comprising at least one of the foregoing intrinsically conductive organic polymers) and a dopant (preferably present in an amount effective to increase the conductivity of the intrinsically conductive organic polymer by two orders of magnitude or more, more preferably wherein the dopant is an organic compound having a boiling point of 120°C or greater, and that is miscible with a solution of the intrinsically conductive organic polymer and water, most preferably wherein the dopant is ethylene glycol, 2-butanone, dimethylsulfoxide, dimethylformamide, glycerol, sorbitol, hexamethylphosphoramide, graphene or a combination comprising at least one of the foregoing dopants, specifically DMSO) in an amount effective to increase the electroconductivity of the intrinsically conductive organic polymer, preferably from 2.0 to 10.0 wt.% based on the weight of the intrinsically conductive organic polymer wherein the active polymer layer comprises poly(3,4-ethylenedioxythiophene)-poly(styrenesulfonate); and the first and second electrodes each comprises dimethylsulfoxide-doped poly(3,4-ethylenedioxythiophene)-poly(styrenesulfonate); the active polymer layer comprises the electroconductive organic polymer of the first and the second electrodes, and the first and the second electrodes have conductivity at least three orders of magnitude higher than the conductivity of the active polymer layer, and wherein disposing the first and second electrodes each comprises forming a layer from a composition comprising an intrinsically conductive polymer, a dopant, and a solvent; and removing the solvent from the layer to provide the electrode; preferably wherein the conductivity of the organic electrode is 900 Siemens/centimeter or greater measured at a thickness of 65 nm, or the conductivity of the organic electrode is less than 900 Siemens/centimeter measured at a thickness of 65 nm, and preferably wherein the resistivity of the organic electrode is 1x10⁵ ohm-cm or less.. The method can further comprise patterning the first electrode, the second electrode, or both, preferably by ink-jet printing.

As used herein "electronic devices" may include one or more electronic components. The one or more electronic components may further include one or more thin-film components, which may be formed of one or more thin films. The term "thin film" refers to a layer of one or more materials formed to a thickness, such that surface properties of the one or more materials may be observed, and these properties may vary from bulk material properties. Thin films may additionally be referred to as component layers, and one or more component layers may comprise one or more layers of material, which may be referred to as material layers, for example. The one or more material or component layers may have electrical or chemical properties, such as conductivity, chemical interface properties, charge flow, or processability.

In general, the compositions and articles disclosed herein can alternatively comprise, consist of, or consist essentially of, any appropriate components herein disclosed. The compositions and articles can additionally, or alternatively, be formulated so as to be devoid, or substantially free, of any components, materials, ingredients, adjuvants or species used in the prior art compositions or that are otherwise not necessary to the achievement of the function and/or objectives of the present compositions.

All ranges disclosed herein are inclusive of the endpoints, and the endpoints are independently combinable with each other. "Combination" is inclusive of blends, mixtures, alloys, reaction products, and the like. Furthermore, the terms "first," "second," and the like, herein do not denote any order, quantity, or importance, but rather are used to denote one element from another. The terms "a" and "an" and "the" herein do not denote a limitation of quantity, and are to be construed to cover both the singular and the plural, unless otherwise indicated herein or clearly contradicted by context. "Or" means "and/or." Reference throughout the specification to "one embodiment," "another embodiment", "an embodiment," and so forth, means that a particular element (e.g., feature, structure, and/or characteristic) described in connection with the embodiment is included in at least one embodiment described herein, and may or may not be present in other embodiments. In addition, it is to be understood that the described elements may be combined in any suitable manner in the various embodiments. The description of a layer being "in contact with" another layer does not preclude the presence of a primer or other surface treatment of the layers.

## Claims

1. A polymer-based device comprising:
a substrate;
a first electrode disposed on the substrate;
an active polymer layer disposed on and in contact with the first electrode; and
a second electrode disposed on and in contact with the active polymer layer, wherein
the first and the second electrodes are organic electrodes comprising a doped electroconductive organic polymer,
**characterised in that**
the active polymer layer comprises the electroconductive organic polymer of the first and the second electrodes, and
the first and the second electrodes have a conductivity at least three orders of magnitude higher than the conductivity of the active polymer layer.

2. The polymer-based device of claim 1, wherein the conductivity of the organic electrodes is 900 Siemens/centimeter or greater measured at a thickness of 65 nm, and wherein resistivity of the organic electrodes is 1x10⁵ ohm-cm or less.

3. The polymer-based device of any one of claims 1 and 2, wherein the doped electroconductive organic polymer comprises an intrinsically conductive organic polymer and a dopant in an amount effective to increase the electroconductivity of the intrinsically conductive organic polymer.

4. The polymer-based device of claim 3, wherein the intrinsically conductive organic polymer is poly(phenylene), poly(naphthalene), poly(azulene), poly(fluorene), poly(pyrene) poly(pyrrole), poly(carbazole), poly(indole), poly(azepine), poly(aniline) poly(thiophene), poly(3,4-ethylenedioxythiophene), poly(p-phenylene-sulfide), poly(acetylene), poly(p-phenylene vinylene), copolymers of the foregoing polymers, or a combination comprising at least one of the foregoing polymers or copolymers.

5. The polymer-based device of claim 4, wherein the intrinsically conductive organic polymer is poly(3,4-ethylenedioxythiophene)-poly(styrenesulfonate), poly(aniline), poly(pyrrole), or a combination comprising at least one of the foregoing intrinsically conductive organic polymers.

6. The polymer-based device of any one of claims 3 to 5, wherein the dopant is present in an amount effective to increase the conductivity of the intrinsically conductive organic polymer by two orders of magnitude or more, and wherein the dopant is an organic compound having a boiling point of 120°C or greater, and that is miscible with a solution of the intrinsically conductive organic polymer and water.

7. The polymer-based device of claim 6, wherein the dopant is ethylene glycol, 2-butanone, dimethylsulfoxide, dimethylformamide, glycerol, sorbitol, hexamethylphosphoramide, graphene or a combination comprising at least one of the foregoing dopants.

8. The polymer-based device of any one of claims 3 to 7, wherein the dopant is present in an amount from 2.0 to 10.0 wt.% based on the weight of the intrinsically conductive organic polymer.

9. The polymer-based device of any one of claims 3 to 8, wherein
the active polymer layer comprises poly(3,4-ethylenedioxythiophene)-poly(styrenesulfonate); and
the first and second electrodes each comprises dimethylsulfoxide-doped poly(3,4-ethylenedioxythiophene)-poly(styrenesulfonate).

10. The polymer-based device of any one of claims 1 to 9, wherein the first electrode, the second electrode, or both, have a thickness of 15 nm to 120 nm.

11. The polymer-based device of any one of claims 1 to 10, wherein the first electrode, the second electrode, or both are patterned.

12. The polymer-based device of any one of claims 1 to 11, wherein the device is flexible.

13. The polymer-based device of any one of claims 1 to 12, wherein the device is a memory device, a capacitor, a transistor, or a diode.

14. A method of making a polymer-based device, the method comprising:
disposing a first electrode on a substrate;
disposing an active polymer layer on the first electrode; and
disposing a second electrode on the active polymer layer, wherein
the first and the second electrodes are organic electrodes comprising a doped electroconductive organic polymer,
the active polymer layer comprises the electroconductive organic polymer of the first and the second electrodes, and
the first and the second electrodes have conductivity at least three orders of magnitude higher than the conductivity of the active polymer layer, and wherein
disposing the first and second electrodes each comprises
forming a layer from a composition comprising an intrinsically conductive polymer, a dopant, and a solvent; and
removing the solvent from the layer to provide the electrode.

15. The method of claim 14, further comprising patterning the first electrode, the second electrode, or both, and wherein the first electrode, the second electrode, or both are ink-jet printed.

## Patentansprüche

1. Polymerbasiertes Bauteil, umfassend:
ein Substrat,
eine erste Elektrode, die auf dem Substrat angeordnet ist,
eine aktive Polymerschicht, die auf der ersten Elektrode angeordnet ist und
damit in Kontakt steht,
eine zweite Elektrode, die auf der aktiven Polymerschicht angeordnet ist und damit in Kontakt steht,
wobei die erste und die zweite Elektrode organische Elektroden sind, die ein dotiertes elektroleitfähiges organisches Polymer enthalten,
**dadurch gekennzeichnet, dass**
die aktive Polymerschicht das elektroleitfähige organische Polymer der ersten und der zweiten Elektrode enthält und
die erste und die zweite Elektrode eine Leitfähigkeit aufweisen, die mindestens drei Größenordnungen höher als die Leitfähigkeit der aktiven Polymerschicht ist.

2. Polymerbasiertes Bauteil nach Anspruch 1, wobei die Leitfähigkeit der organischen Elektroden 900 Siemens/Zentimeter oder mehr beträgt, gemessen bei einer Dicke von 65 nm, und wobei der spezifische Widerstand der organischen Elektroden 1x10⁵ Ohm-cm oder weniger beträgt.

3. Polymerbasiertes Bauteil nach einem der Ansprüche 1 und 2, wobei das dotierte elektroleitfähige organische Polymer ein intrinsisch leitfähiges organisches Polymer und ein Dotierungsmittel in einer Menge, die wirksam ist, um die Elektroleitfähigkeit des intrinsisch leitfähigen organischen Polymers zu erhöhen, enthält.

4. Polymerbasiertes Bauteil nach Anspruch 3, wobei das intrinsisch leitfähige organische Polymer Polyphenylen, Polynaphthalin, Polyazulen, Polyfluoren, Polypyren, Polypyrrol, Polycarbazol, Polyindol, Polyazepin, Polyanilin, Polythiophen, Poly-3,4-ethylendioxythiophen, Poly(p-phenylensulfid), Polyacetylen, Poly(p-phenylen-vinylen), Copolymere der vorstehenden Polymere oder eine Kombination, die mindestens eines der vorstehenden Polymere oder Copolymere enthält, ist.

5. Polymerbasiertes Bauteil nach Anspruch 4, wobei das intrinsisch leitfähige organische Polymer Poly(3,4-ethylendioxythiophen)-poly(styrolsulfonat), Poly(anilin), Poly(pyrrol) oder eine Kombination, die mindestens eines der vorstehenden intrinsisch leitfähigen organischen Polymere enthält, ist.

6. Polymerbasiertes Bauteil nach einem der Ansprüche 3 bis 5, wobei das Dotierungsmittel in einer Menge vorhanden ist, die wirksam ist, um die Leitfähigkeit des intrinsisch leitfähigen organischen Polymers um zwei Größenordnungen oder mehr zu erhöhen, und wobei das Dotierungsmittel eine organische Verbindung mit einem Siedepunkt von 120 °C oder größer ist, die mit einer Lösung des intrinsisch leitfähigen organischen Polymers und Wasser mischbar ist.

7. Polymerbasiertes Bauteil nach Anspruch 6, wobei das Dotierungsmittel Ethylenglykol, 2-Butanon, Dimethylsulfoxid, Dimethylformamid, Glycerin, Sorbitol, Hexamethylphosphoramid, Graphen oder eine Kombination, die mindestens eines der vorstehenden Dotierungsmitteln enthält, ist.

8. Polymerbasiertes Bauteil nach einem der Ansprüche 3 bis 7, wobei das Dotierungsmittel in einer Menge von 2,0 bis 10,0 Gew.-%, bezogen auf das Gewicht des intrinsisch leitfähigen organischen Polymers, vorhanden ist.

9. Polymerbasiertes Bauteil nach einem der Ansprüche 3 bis 8, wobei die aktive Polymerschicht Poly(3,4-ethylendioxythiophen)-poly(styrolsulfonat) enthält und
die erste und zweite Elektrode jeweils mit Dimethylsulfoxid dotiertes Poly(3,4-ethylendioxythiophen)-poly(styrolsulfonat) enthalten.

10. Polymerbasiertes Bauteil nach einem der Ansprüche 1 bis 9, wobei die erste Elektrode, die zweite Elektrode oder beide eine Dicke von 15 nm bis 120 nm aufweisen.

11. Polymerbasiertes Bauteil nach einem der Ansprüche 1 bis 10, wobei die erste Elektrode, die zweite Elektrode oder beide gemustert sind.

12. Polymerbasiertes Bauteil nach einem der Ansprüche 1 bis 11, wobei das Bauteil flexibel ist.

13. Polymerbasiertes Bauteil nach einem der Ansprüche 1 bis 12, wobei das Bauteil ein Speichermedium, ein Kondensator, ein Transistor oder eine Diode ist.

14. Verfahren zur Herstellung eines polymerbasierten Bauteils, wobei das Verfahren umfasst:
Anordnen einer ersten Elektrode auf einem Substrat,
Anordnen einer aktiven Polymerschicht auf der ersten Elektrode und
Anordnen einer zweiten Elektrode auf der aktiven Polymerschicht,
wobei
die erste und die zweite Elektrode organische Elektroden sind, die ein dotiertes elektroleitfähiges organisches Polymer enthalten,
die aktive Polymerschicht das elektroleitfähige organische Polymer der ersten und zweiten Elektrode enthält, und
die erste und zweite Elektrode eine Leitfähigkeit aufweisen, die um mindestens drei Größenordnungen höher als die Leitfähigkeit der aktiven Polymerschicht ist, und wobei
Anordnen der ersten und zweiten Elektrode jeweils umfasst:
Ausbilden einer Schicht aus einer Zusammensetzung, die ein intrinsisch leitfähiges Polymer, ein Dotierungsmittel und ein Lösungsmittel enthält, und
Entfernen des Lösungsmittels aus der Schicht, um die Elektrode bereitzustellen.

15. Verfahren nach Anspruch 14, das ferner das Versehen der ersten Elektrode, der zweiten Elektrode oder beider mit einem Muster umfasst, und wobei die erste Elektrode, die zweite Elektrode oder beide tintenstrahlbedruckt werden.

## Revendications

1. Dispositif à base de polymère comprenant :
un substrat ;
une première électrode disposée sur le substrat ;
une couche de polymère actif disposée sur et en contact avec la première électrode ; et
une deuxième électrode disposée sur et en contact avec la couche de polymère actif, dans lequel
les première et deuxième électrodes sont des électrodes organiques comprenant un polymère organique électro-conducteur dopé,
**caractérisé en ce que**
la couche de polymère actif comprend le polymère organique électro-conducteur des première et deuxième électrodes, et
les première et deuxième électrodes ont une conductivité d'au moins trois ordres de grandeur supérieure à la conductivité de la couche de polymère actif.

2. Dispositif à base de polymère selon la revendication 1, dans lequel la conductivité des électrodes organiques est de 900 Siemens/centimètre ou supérieure, mesurée à une épaisseur de 65 nm, et dans lequel la résistivité des électrodes organiques est de 1 x 10⁵ ohm-cm ou moins.

3. Dispositif à base de polymère selon l'une quelconque des revendications 1 et 2, dans lequel le polymère organique électro-conducteur dopé comprend un polymère organique intrinsèquement conducteur et un dopant en une quantité efficace pour augmenter l'électro-conductivité du polymère organique intrinsèquement conducteur.

4. Dispositif à base de polymère selon la revendication 3, dans lequel le polymère organique intrinsèquement conducteur est le poly(phénylène), le poly(naphtalène), le poly(azulène), le poly(fluorène), le poly(pyrène), le poly(pyrrole), le poly(carbazole), le poly(indole), la poly(azépine), la poly(aniline), le poly(thiophène), le poly(3,4-éthylènedioxythiophène), le poly(p-phénylène-sulfure), le poly(acétylène), le poly(p-phénylène vinylène), des copolymères des polymères précédents ou une combinaison comprenant au moins l'un des polymères ou copolymères précédents.

5. Dispositif à base de polymère selon la revendication 4, dans lequel polymère organique intrinsèquement conducteur est le poly(3,4-éthylènedioxythiophène)-poly(styrènesulfonate), la poly(aniline), le poly(pyrrole) ou une combinaison comprenant au moins un des polymères organiques intrinsèquement conducteurs précédents.

6. Dispositif à base de polymère selon l'une quelconque des revendications 3 à 5, dans lequel le dopant est présent en une quantité efficace pour augmenter la conductivité du polymère organique intrinsèquement conducteur de deux ordres de grandeur ou plus, et dans lequel le dopant est un composé organique ayant un point d'ébullition de 120 °C ou supérieur et qui est miscible avec une solution du polymère organique intrinsèquement conducteur et de l'eau.

7. Dispositif à base de polymère selon la revendication 6, dans lequel le dopant est l'éthylène glycol, le 2-butanone, le diméthylsulfoxyde, le diméthylformamide, le glycérol, le sorbitol, l'hexaméthylphosphoramide, le graphène ou une combinaison comprenant au moins l'un des dopants précédents.

8. Dispositif à base de polymère selon l'une quelconque des revendications 3 à 7, dans lequel le dopant est présent en une quantité de 2,0 à 10,0 % en poids sur la base du poids du polymère organique intrinsèquement conducteur.

9. Dispositif à base de polymère selon l'une quelconque des revendications 3 à 8, dans lequel la couche de polymère actif comprend du poly(3,4-éthylènedioxythiophène)-poly(styrènesulfonate) ; et
les première et deuxième électrodes comprennent chacune du poly(3,4-éthylènedioxythiophène)-poly(styrènesulfonate) dopé au diméthylsulfoxyde.

10. Dispositif à base de polymère selon l'une quelconque des revendications 1 à 9, dans lequel la première électrode, la deuxième électrode ou les deux ont une épaisseur de 15 nm à 120 mm.

11. Dispositif à base de polymère selon l'une quelconque des revendications 1 à 10, dans lequel la première électrode, la deuxième électrode ou les deux sont structurées.

12. Dispositif à base de polymère selon l'une quelconque des revendications 1 à 11, dans lequel le dispositif est flexible.

13. Dispositif à base de polymère selon l'une quelconque des revendications 1 à 12, dans lequel le dispositif est un dispositif de mémoire, un condensateur, un transistor ou une diode.

14. Procédé pour fabriquer un dispositif à base de polymère, le procédé comprenant :
la disposition d'une première électrode sur un substrat ;
la disposition d'une couche de polymère actif sur la première électrode ; et
la disposition d'une deuxième électrode sur la couche de polymère actif,
dans lequel
les première et deuxième électrodes sont des électrodes organiques comprenant un polymère organique électro-conducteur dopé,
la couche de polymère actif comprend le polymère organique électro-conducteur des première et deuxième électrodes, et
les première et deuxième électrodes ont une conductivité d'au moins trois ordres de grandeur supérieure à la conductivité de la couche de polymère actif, et
dans lequel
la disposition des première et deuxième électrodes comprend chacune
la formation d'une couche d'une composition comprenant un polymère intrinsèquement conducteur, un dopant, et un solvant ; et
l'élimination du solvant de la couche pour obtenir l'électrode.

15. Procédé selon la revendication 14, comprenant en outre le façonnage de la première électrode, de la deuxième électrode, ou des deux, et dans lequel la première électrode, la deuxième électrode, ou les deux sont imprimées par jet d'encre.
